# EUROPEAN PATENT APPLICATION

(11) **EP 4 836 659 A1**
(43) Date of publication of application: **04.11.2026**
(21) Application number: 25814135.7
(22) Date of filing: 23.01.2025
(51) Int. Cl.: H10K 71/00

(54) **BATTERY PRODUCTION APPARATUS**

(30) Priority: 27.05.2024 CN 202421172714 U
(71) Applicant: Contemporary Amperex Technology Co., Limited, Ningde, Fujian 352100 (CN)
(72) Inventor: QIU, Yongshuai, Ningde, Fujian 352100 (CN); LIAO, Shaoyang, Ningde, Fujian 352100 (CN); LIN, Longjun, Ningde, Fujian 352100 (CN); WANG, Xiang, Ningde, Fujian 352100 (CN); HUANG, Shuhan, Ningde, Fujian 352100 (CN); TU, Bao, Ningde, Fujian 352100 (CN); LIN, Weile, Ningde, Fujian 352100 (CN); CHEN, Guodong, Ningde, Fujian 352100 (CN)
(74) Representative: Lorenz Seidler Gossel Part. mbB
(86) International application number: PCT/CN2025/074201
(87) International publication number: WO 2025/246411

(57) **Abstract**

The present application relates to a battery production apparatus. The battery production apparatus comprises a support, conveying mechanisms and heat exchange assemblies, wherein the conveying mechanisms are arranged on the support and are used for receiving and conveying a substrate; and the heat exchange assemblies are arranged on the support and located on a conveyance path of the substrate, and are used for exchanging heat with the substrate. The battery production apparatus provided in the present application achieves the normal conveyance and the cooling of the substrate, reduces the impact of thermal stress in the next process, and also shortens or eliminates the placement time for the substrate before entering the next process.

## Description

### CROSS-REFERENCE TO RELATED APPLICATIONS

This application claims priority to Chinese Patent Application No. 202421172714.6, filed on May 27, 2024 and entitled "BATTERY PRODUCTION DEVICE", which is incorporated herein by reference in its entirety.

### TECHNICAL FIELD

This application relates to the field of battery production technologies, and in particular, to a battery production device.

### BACKGROUND

As science develops, breakthroughs in new energy development are constantly being made, and solar cells represented by perovskite solar cells and organic thin-film solar cells have witnessed disruptive advancements. Because of advantages such as high efficiency and low costs, these kinds of solar cells have already been widely used in sectors such as aerospace, industry, commerce, agriculture, and communication. The perovskite solar cells (perovskite solar cells) are apparatuses that convert solar energy into electrical energy by utilizing a photoelectric conversion mechanism of perovskite-type crystalline materials. Being third-generation solar cells currently, the perovskite solar cells have a plurality of advantages such as high photoelectric conversion efficiency, a simple production process, and low production costs, and have been extensively studied in recent years.

During development of solar cell technologies, how to improve reliability of solar cells is an urgent technical problem to resolve in the solar cell technologies.

### SUMMARY

This application provides a battery production device, to improve reliability of solar cells to some extent.

According to a first aspect, this application provides a battery production device. The battery production device includes a support, a conveyor mechanism, and a heat exchange assembly. The conveyor mechanism is disposed on the support and configured to receive a substrate and convey the substrate. The heat exchange assembly is disposed on the support and located on a path of conveying the substrate. The heat exchange assembly is configured to exchange heat with the substrate.

According to the battery production device provided in this application, the heat exchange assembly is disposed, and integrated on the path of conveying the substrate, properly conveying and cooling the substrate. In this way, impact of thermal stress on a next process is reduced, and a standing time required before the substrate proceeds to the next process is shortened or eliminated. In addition, after the substrate is conveyed by the conveyor mechanism, a water contact angle of the substrate decreases, improving wettability of the substrate, stability of a formed perovskite layer, and further reliability of a perovskite solar cell.

According to an embodiment of this application, the heat exchange assembly is disposed on at least two sides of the conveyor mechanism along a first direction, and the first direction, a direction of conveying the substrate, and a vertical direction of the support are mutually perpendicular to each other.

In these optional embodiments, such a setting can bring an increase in an area of a region in which the heat exchange assembly and the substrate correspond to each other, improving efficiency of heat exchange.

According to an embodiment of this application, the conveyor mechanism includes a plurality of conveyor belts spaced apart the first direction, and the heat exchange assembly is further disposed between two adjacent ones of the conveyor belts.

In these optional embodiments, such a setting can bring an increase in a density of heat exchange assemblies in a region in which the heat exchange assemblies are opposite the substrate, so that heat released by the substrate can be quickly transferred to the heat exchange assemblies, featuring high efficiency of heat transfer and improving efficiency of cooling.

According to an embodiment of this application, an upper side of the heat exchange assembly has a heat exchange plane, and the heat exchange plane is configured to be attached to the substrate.

In these optional embodiments, the upper side of the heat exchange assembly has the heat exchange plane. Therefore, there is a large contact area between the heat exchange assembly and the substrate, improving efficiency of heat transfer.

According to an embodiment of this application, the heat exchange assembly includes a heat exchange plate, a runner is provided within the heat exchange plate, and the runner is configured to guide flow of a heat exchange medium.

In these optional embodiments, the runner can guide flow of the heat exchange medium, quickly carrying away heat from the substrate and continuously cooling the substrate.

According to an embodiment of this application, the heat exchange plate is made of a material selected from aluminum or an aluminum alloy.

In these optional embodiments, aluminum or an aluminum alloy is a thermally conductive material and exhibits good thermal conductivity, facilitating quick heat dissipation and cooling for the substrate.

According to an embodiment of this application, the battery production device further includes an attachment piece, the attachment piece is configured to be disposed on a side of the heat exchange assembly facing the substrate, and the attachment piece is connected to the heat exchange assembly and configured to be attached to the substrate.

In these optional embodiments, the attachment piece is disposed, to facilitate stable contact between the heat exchange assembly and the substrate and reduce a gap between the heat exchange assembly and the substrate, improving cooling effect. In addition, disposing of the attachment piece plays a role of cushioning to some extent, avoiding direct contact between the substrate and the extremely cold heat exchange assembly, and cushioning cooling of the substrate to some extent.

According to an embodiment of this application, the battery production device further includes an air extraction piece, and the air extraction piece communicates with the attachment piece.

In these optional embodiments, the air extraction piece is disposed, to facilitate controlling the attachment piece to attach to or detach from the substrate.

According to an embodiment of this application, the attachment piece at least partially protrudes from the heat exchange assembly.

In these optional embodiments, the attachment piece protruding from the heat exchange assembly creates a small gap between the substrate and the heat exchange assembly. In this case, while cooling effect is achieved, the substrate is prevented from suddenly being in contact with the extremely cold heat exchange assembly, allowing the substrate to cool down gradually and stably.

According to an embodiment of this application, the heat exchange assembly includes a heat exchange plate, a recess portion recessed inwards is provided on a surface of the heat exchange plate facing the substrate, and part of the attachment piece is disposed in the recess portion.

In these optional embodiments, part of the attachment piece is disposed in the recess portion, further reducing a gap between the heat exchange plate and the substrate, improving efficiency of heat exchange, and enhancing effect of cooling the substrate.

According to an embodiment of this application, the attachment piece is made of polytetrafluoroethylene.

In these optional embodiments, the attachment piece made of polytetrafluoroethylene can effectively reduce damage to the attachment piece caused by the high-temperature substrate. In addition, polytetrafluoroethylene is hydrophobic and oleophobic, effectively reducing oil contamination of the substrate.

According to an embodiment of this application, the battery production device further includes a drive piece, the drive piece is connected to the heat exchange assembly, and the drive piece drives the heat exchange assembly to move upwards or downwards.

According to an embodiment of this application, the battery production device further includes a temperature detector disposed on the support, and the temperature detector is configured to detect a temperature of the substrate.

In these optional embodiments, the drive piece is disposed, to drive the heat exchange assembly to move upwards or downwards. The heat exchange assembly and the conveyor mechanism operate independently of each other, reducing interference caused by the heat exchange assembly to normal conveyance of the substrate on the conveyor mechanism.

The foregoing descriptions are merely a summary of technical solutions of this application. For purposes of helping understand technical means of this application more clearly so that implementations can be carried out according to the content of this specification, and making the foregoing and other objectives, features, and advantages of this application clearer and easier to understand, the following especially lists specific implementations of this application.

### BRIEF DESCRIPTION OF DRAWINGS

The following describes features, advantages, and technical effects of example embodiments of this application with reference to accompanying drawings.
FIG. 1 is a diagram of structures of a battery production device and a substrate according to an embodiment of this application;
FIG. 2 is a diagram of a structure of a battery production device according to an embodiment of this application;
FIG. 3 is a front view of a battery production device according to an embodiment of this application;
FIG. 4 is a diagram of a structure of a battery production device according to another embodiment of this application;
FIG. 5 is a diagram of a structure of a heat exchange assembly of a battery production device according to an embodiment of this application;
FIG. 6 is a diagram of cooling effect of a substrate according to this application; and
FIG. 7 is a diagram of a result of a water contact angle test performed for a substrate according to this application.

The accompanying drawings are not necessarily drawn to actual scale.

### Description of reference numerals:

1. substrate;
100. battery production device;
10. support;
20. conveyor mechanism; 21. conveyor belt;
30. heat exchange assembly; 31. heat exchange plane; 32. heat exchange plate; 321. runner; 322. recess portion;
40. attachment piece;
50. air extraction piece;
60. drive piece;
70. temperature detector;
x. first direction; y. conveying direction; and z. vertical direction.

### DESCRIPTION OF EMBODIMENTS

To make objectives, technical solutions, and advantages of embodiments of this application clearer, the following clearly describes the technical solutions in embodiments of this application with reference to the accompanying drawings in embodiments of this application. It is clear that the described embodiments are some rather than all of embodiments of this application. All other embodiments obtained by persons of ordinary skill in the art based on embodiments of this application without creative efforts fall within the scope of protection of this application.

Unless otherwise defined, all technical and scientific terms used in this application have the same meaning as commonly understood by persons skilled in the technical field of this application; the terms used in this specification of this application are only for the purpose of describing specific embodiments and are not intended to limit this application; the terms "include", "have", and any variations thereof in the specification, claims, and descriptions of the accompanying drawings of this application are intended to cover non-exclusive inclusion. The terms such as "first" and "second" in the specification and claims, or accompanying drawings of this application are used to distinguish between different objects, rather than to describe a particular order or primary-secondary relationship.

In this application, reference to "embodiment" means that specific features, structures, or characteristics described with reference to the embodiment may be included in at least one embodiment of this application. The appearance of this phrase in various places in the specification does not necessarily refer to the same embodiment, nor is it an independent or alternative embodiment mutually exclusive with other embodiments.

In the description of this application, it should be noted that, unless otherwise explicitly specified and defined, terms such as "mounting", "connection", "joint", and "attaching" should be understood in a broad sense. For example, it may be a fixed connection, a detachable connection, or an integral connection; it may be a direct connection or an indirect connection through an intermediate medium; and it may be an internal communication between two elements. For persons of ordinary skill in the art, the specific meanings of the above terms in this application can be understood based on specific circumstances.

In this application, the term "and/or" is only an associative relationship for describing associated objects, indicating that three relationships may be present. For example, A and/or B may indicate the following three cases: presence of only A, presence of both A and B, and presence of only B. In addition, the character "/" in this application generally indicates that the contextually associated objects are in an "or" relationship.

In embodiments of this application, identical reference numerals represent identical components. In addition, for brevity, detailed descriptions of identical components are omitted in different embodiments. It should be understood that dimensions such as thicknesses, lengths, and widths of various components, and dimensions such as an overall thickness, an overall length, and an overall width of an integrated apparatus in embodiments of this application shown in the accompanying drawings are merely examples, and shall not constitute any limitation on this application.

In this application, "a plurality of" means two or more (including two).

In a technology related to perovskite solar cells, a substrate is used as a base, and a hole-transporting layer is formed on the substrate. After laser processing is performed on the hole-transporting layer, a perovskite layer is then formed on the hole-transporting layer. Usually, the hole-transporting layer is formed on the base by a coating apparatus. After being unloaded from the coating apparatus, the substrate needs to be conveyed by a conveyor mechanism, and then undergoes laser processing at a laser scribing apparatus. However, a temperature of the substrate that is unloaded from the coating apparatus is excessively high. Consequently, after laser scribing is performed, some line segments bend due to impact of thermal stress, resulting in an increase in a dead area. Although the unloaded substrate can be cooled naturally, cleaning effect worsens after laser scribing is performed, adversely affecting formation of the perovskite layer, and reducing reliability of a perovskite solar cell. The foregoing descriptions are merely used to provide background information related to this application, and do not necessarily constitute the conventional technology.

In view of the foregoing problem, according to a battery production device provided in this application, a heat exchange assembly is disposed, and integrated on a path of conveying a substrate, properly conveying and cooling the substrate. In this way, impact of thermal stress on a next process is reduced, and a standing time required before the substrate proceeds to the next process is shortened or eliminated. In addition, after the substrate is conveyed by a conveyor mechanism, a water contact angle of the substrate decreases, improving wettability of the substrate, stability of a formed perovskite layer, and further reliability of a perovskite solar cell.

The battery production device disclosed in this application may be used to manufacture solar cells. The solar cells may be, but are not limited to, perovskite solar cells. In addition, a cell disclosed in this application may be used in an electrical apparatus, including but not limited to a vehicle, a ship, or an aircraft. The cell disclosed in this application and the like may be used to constitute a power system of the electrical apparatus.

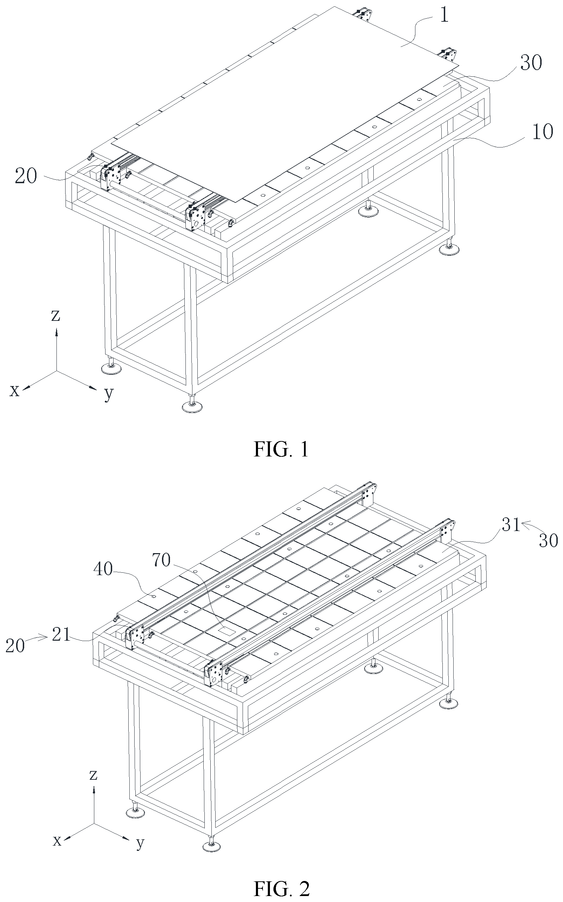

Refer to FIG. 1. FIG. 1 is a diagram of structures according to an embodiment of this application.

As shown in FIG. 1, this application provides a battery production device 100. The battery production device 100 includes a support 10, a conveyor mechanism 20, and a heat exchange assembly 30. The conveyor mechanism 20 is disposed on the support 10 and configured to receive a substrate 1 and convey the substrate 1. The heat exchange assembly 30 is disposed on the support 10 and located on a path of conveying the substrate 1. The heat exchange assembly 30 is configured to exchange heat with the substrate 1.

For a purpose of providing a solar cell with specific structural strength, the substrate 1 is used as a base for the solar cell, and other layers such as a transporting layer are formed on the substrate 1.

The substrate 1 may also be referred to as a base. A material of the substrate 1 may be, but is not limited to, glass, tempered glass, quartz, an organic flexible material, or the like. Certainly, the material of the substrate 1 may alternatively be transparent conductive glass, a stainless steel conductive flexible base, a conductive flexible base made of polyethylene glycol terephthalate (polyethylene glycol terephthalate, PET), or the like.

Specifically, the battery production device 100 further includes a coating apparatus. After being unloaded from the coating apparatus, the substrate 1 is placed on the conveyor mechanism 20 to be conveyed to a next process.

As a basic component of the battery production device 100, the support 10 is configured for mounting and carrying other components, such as the conveyor mechanism 20 and the heat exchange assembly 30. The support 10 may be in a plurality of regular shapes such as a cuboid, a cube, and a cylinder, or may be in other irregular shapes. A shape of the support 10 shall not affect normal conveying of the conveyor mechanism 20 or cooling performed by the heat exchange assembly 30 for the substrate 1. A specific shape of the support 10 is not limited in this application. The support 10 may also be made of a plurality of materials, such as steel, aluminum alloys, or other composites.

The conveyor mechanism 20 is configured to receive the substrate 1 and convey the substrate 1 to a downstream apparatus.

In an embodiment of this application, the conveyor mechanism 20 may include one or more conveying lanes. When a plurality of conveying lanes are included, conveying paths of the conveying lanes may be the same or different, to achieve synchronous conveyance for a plurality of substrates 1 so as to speed up conveyance for the plurality of substrates 1.

For example, the conveyor mechanism 20 may include gear transmission, chain transmission, belt transmission, shaft transmission, and the like.

The heat exchange assembly 30 is configured to exchange heat with the substrate 1, to achieve temperature regulation.

Specifically, the heat exchange assembly 30 is located on the path of conveying the substrate 1, and exchanges heat with the substrate 1 that is on the conveyor mechanism 20. The heat exchange assembly 30 may be fastened to the support 10, to cool the substrate 1 that passes the heat exchange assembly 30; or the heat exchange assembly 30 may be movably disposed on the support 10 and moves along the path of conveying the substrate 1, to continuously cool the substrate 1 that is on the conveyor mechanism 20; or the heat exchange assembly 30 may be temporarily attached to a surface of the substrate 1 to cool the substrate 1, and in this case, the substrate 1 may be temporarily in a stationary state or may be in a moving state.

For example, the heat exchange assembly 30 uses a heat exchange pipeline. The heat exchange pipeline is configured to guide flow of a heat exchange medium. The heat exchange medium flowing in the heat exchange pipeline can quickly carry away heat.

For example, the heat exchange assembly 30 uses a surface cooler.

According to the battery production device 100 provided in this application, the heat exchange assembly 30 is disposed, and integrated on the path of conveying the substrate 1, properly conveying and cooling the substrate 1. In this way, impact of thermal stress on the next process is reduced, and a standing time required before the substrate 1 proceeds to the next process is shortened or eliminated. In addition, after the substrate 1 is conveyed by the conveyor mechanism 20, a water contact angle of the substrate 1 decreases, improving wettability of the substrate 1, stability of a formed perovskite layer, and further reliability of a perovskite solar cell.

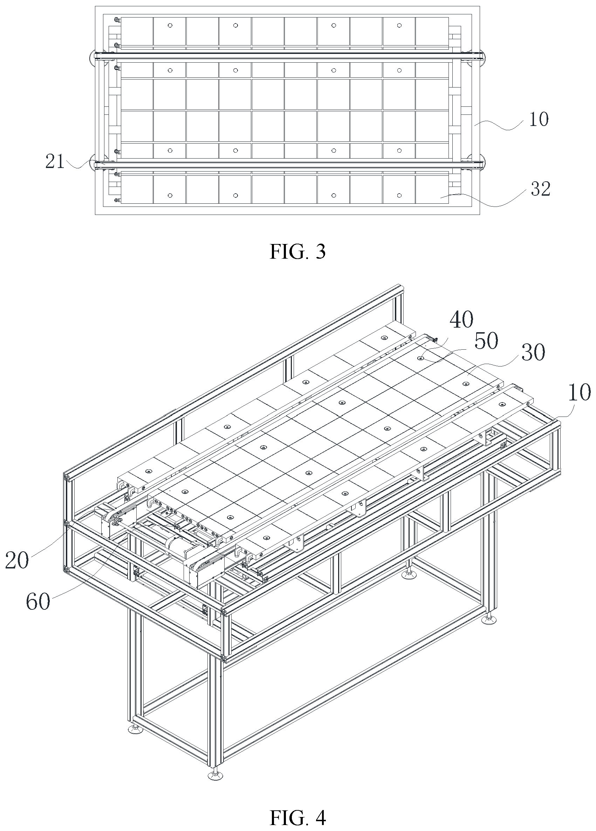

Refer to both FIG. 2 and FIG. 3. FIG. 2 is a diagram of a structure of a battery production device according to an embodiment of this application. FIG. 3 is a front view of a battery production device according to an embodiment of this application.

According to an embodiment of this application, as shown in FIG. 2 and FIG. 3, the heat exchange assembly 30 is disposed on at least two sides of the conveyor mechanism 20 along a first direction x, and the first direction x, a direction y of conveying the substrate 1, and a vertical direction z of the support 10 are mutually perpendicular to each other.

In an embodiment of this application, the battery production device 100 includes at least two heat exchange assemblies 30, and the two heat exchange assemblies 30 are disposed on the two sides of the conveyor mechanism 20 along the first direction x, respectively.

Specifically, a projection of the conveyor mechanism 20 along the vertical direction z of the support 10 falls within the substrate 1. It may be understood as that an area of the conveyor mechanism 20 is less than that of the substrate 1, to increase a contact or overlapping area between the heat exchange assembly 30 and the substrate 1, so as to increase a heat exchange area.

Optionally, along the vertical direction z of the support 10, the heat exchange assembly 30 at least partially overlaps the substrate 1.

In these optional embodiments, such a setting can bring an increase in an area of a region in which the heat exchange assembly 30 and the substrate 1 correspond to each other, improving efficiency of heat exchange.

According to an embodiment of this application, the conveyor mechanism 20 includes a plurality of conveyor belts 21 that are disposed along the first direction x and spaced apart, and the heat exchange assembly 30 is further disposed between two adjacent ones of the conveyor belts 21.

Specifically, the conveyor mechanism 20 includes N conveyor belts 21 that are disposed along the first direction x and spaced apart. The battery production device 100 includes N+1 conveyor mechanisms 20. A conveyor mechanism 20 is disposed on each of two sides of each conveyor belt 21 along the first direction x. It may be understood as that, in the first direction x, the conveyor belts 21 and the heat exchange assemblies 30 are alternately disposed along the first direction x. Each conveyor belt 21 may convey a substrate 1 on its own, or a plurality of conveyor belts 21 jointly convey a substrate 1.

For example, the conveyor mechanism 20 includes a first conveyor belt and a second conveyor belt that are disposed along the first direction x and spaced apart, and the substrate 1 is configured to be conveyed on the first conveyor belt and the second conveyor belt. The conveyor mechanism 20 further includes a first heat exchange assembly, a second heat exchange assembly, and a third heat exchange assembly that are disposed along the first direction x and spaced apart. The first heat exchange assembly and the second heat exchange assembly are disposed on two sides of the first conveyor belt along the first direction x, and the second heat exchange assembly and the third heat exchange assembly are disposed on two sides of the second conveyor belt along the first direction x.

Optionally, the conveyor mechanism 20 extends along the direction y of conveying the substrate 1.

In these optional embodiments, such a setting can bring an increase in a density of heat exchange assemblies 30 in a region in which the heat exchange assemblies 30 are opposite the substrate 1, so that heat released by the substrate 1 can be quickly transferred to the heat exchange assemblies 30, featuring high efficiency of heat transfer and improving efficiency of cooling.

According to an embodiment of this application, as shown in FIG. 2 and FIG. 3, an upper side of the heat exchange assembly 30 has a heat exchange plane 31, and the heat exchange plane 31 is configured to be attached to the substrate 1.

In an embodiment of this application, the upper side of the heat exchange assembly 30 has a heat exchange plane 31, and the heat exchange plane 31 may be attached to the substrate 1, to increase a contact area between the heat exchange assembly 30 and the substrate 1. Optionally, in a process in which the heat exchange plane 31 of the heat exchange assembly 30 is attached to the substrate 1, the substrate 1 may not be conveyed temporarily, and after a temperature of the substrate 1 decreases to a preset temperature, the heat exchange assembly 30 is separated from the substrate 1, and the conveyor mechanism 20 continues to convey the substrate 1.

Optionally, the substrate 1 has a first surface and a second surface that are opposite each other along a thickness direction. The second surface is located on a lower side and is a plane. The heat exchange plane 31 on the upper side of the heat exchange assembly 30 is attached to the second surface.

In these optional embodiments, the upper side of the heat exchange assembly 30 has the heat exchange plane 31. Therefore, there is a large contact area between the heat exchange assembly 30 and the substrate 1, improving efficiency of heat transfer.

According to an embodiment of this application, the heat exchange assembly 30 includes a heat exchange plate 32, a runner 321 is provided within the heat exchange plate 32, and the runner 321 is configured to guide flow of a heat exchange medium.

The runner 321 is provided within the heat exchange plate 32, and the runner 321 is configured to guide flow of a heat exchange medium. The heat exchange medium flowing in the runner 321 can quickly carry away heat from the substrate 1. The heat exchange medium is a fluid medium, for example, water, ethanol, oil, or Freon. The heat exchange medium may absorb heat from the substrate 1, or the fluid heat exchange medium carries heat from the substrate 1 to an external environment, to achieve cooling.

For example, the heat exchange plate 32 includes a first plate and a second plate, with the first plate and the second plate stacked along a thickness direction of the heat exchange plate 32. A guide groove is provided on the first plate. The second plate has a first surface and a second surface that are provided opposite each other along a thickness direction. The first surface is provided to be in contact with the substrate 1. The second surface is connected to the first plate and covers the guide groove, to enclose the runner 321. In such a setting, the guide groove can be directly provided on the semi-finished first plate, simplifying a structure of the runner 321.

In some embodiments, the runner 321 may be wavy, serrated, S-shaped, or the like.

Optionally, the heat exchange assembly 30 includes a heat exchange plate 32, and a surface of a side of the heat exchange plate 32 facing the substrate 1 is a plane.

In these optional embodiments, the runner 321 can guide flow of the heat exchange medium, quickly carrying away heat from the substrate 1 and continuously cooling the substrate 1.

According to an embodiment of this application, the heat exchange assembly 30 further includes a joint. The joint is disposed on the heat exchange plate 32 and communicates with the runner 321.

In an embodiment of this application, the heat exchange assembly 30 includes a heat exchange plate 32 and a joint. A runner 321 is provided within the heat exchange plate 32. The joint is disposed on the heat exchange plate 32 and communicates with the runner 321. A heat exchange medium flows into or out of the runner 321 through the joint. The heat exchange medium flows in the runner 321 and absorbs some of heat through heat exchange, cooling the substrate 1.

For example, the heat exchange assembly 30 includes a joint. Through the joint, a heat exchange medium may be guided into the runner 321, and also through the joint, a heat exchange medium may be guided out of the runner 321.

For example, the heat exchange assembly 30 includes a plurality of joints. At least one of the plurality of joints is configured to guide a heat exchange medium into the runner 321, and at least one of the plurality of joints is configured to guide a heat exchange medium out of the runner 321. The plurality of joints may be disposed at one end of the heat exchange plate 32, or may be respectively disposed at two ends of the heat exchange plate 32.

In these optional embodiments, the joint is connected to the heat exchange plate 32, making it easy to mount and remove the joint, and causing a minor change to an overall structure of the heat exchange plate 32. In addition, disposing of the joint can allow the heat exchange medium to keep flowing, achieving continuous heat dissipation.

According to an embodiment of this application, the heat exchange plate 32 is made of a material selected from aluminum or an aluminum alloy.

In these optional embodiments, aluminum or an aluminum alloy is a thermally conductive material and exhibits good thermal conductivity, facilitating quick heat dissipation and cooling for the substrate 1.

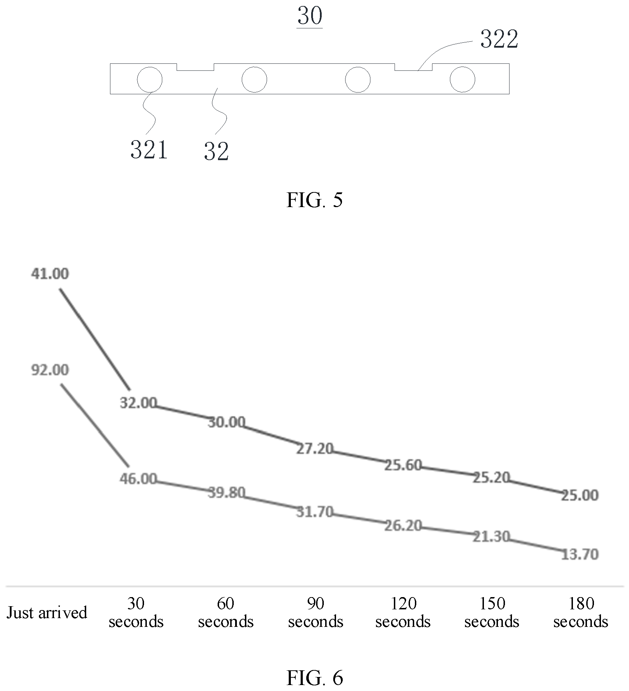

Refer to FIG. 4 and FIG. 5 together. FIG. 4 is a diagram of a structure of a battery production device according to another embodiment of this application. FIG. 5 is a diagram of a structure of a heat exchange assembly of a battery production device according to an embodiment of this application.

According to an embodiment of this application, as shown in FIG. 4 and FIG. 5, the battery production device 100 further includes an attachment piece 40, the attachment piece 40 is configured to be disposed on a side of the heat exchange assembly 30 facing the substrate 1, and the attachment piece 40 is connected to the heat exchange assembly 30 and configured to be attached to the substrate 1.

In an embodiment of this application, the battery production device 100 further includes an attachment piece 40. The attachment piece 40 is disposed on a side of the heat exchange assembly 30 facing the substrate 1. The attachment piece 40 is attached to the substrate 1, so that the heat exchange assembly 30 can be connected to the substrate 1 via the attachment piece 40 and cool the substrate 1. When the substrate 1 is conveyed to a predetermined position by the conveyor mechanism 20, or when the substrate 1 is placed on the conveyor mechanism 20, the heat exchange assembly 30 is attached to the substrate 1 via the attachment piece 40, to cool the substrate 1. After the substrate 1 cools down to the preset temperature, the attachment piece 40 is detached, separating the heat exchange assembly 30 from the substrate 1.

Optionally, the attachment piece 40 may be attached to the substrate 1 by use of a sucker, an adhesive tape, an electrostatic piece, or the like.

The battery production device 100 includes one or more attachment pieces 40. When the battery production device 100 includes a plurality of attachment pieces 40, the plurality of attachment pieces 40 are disposed on the heat exchange assembly 30 along the conveying direction y and spaced apart, so that the substrate 1 is in closer contact with the heat exchange assembly 30.

In these optional embodiments, the attachment piece 40 is disposed, to facilitate stable contact between the heat exchange assembly 30 and the substrate 1 and reduce a gap between the heat exchange assembly 30 and the substrate 1, improving cooling effect. In addition, disposing of the attachment piece 40 plays a role of cushioning to some extent, avoiding direct contact between the substrate 1 and the extremely cold heat exchange assembly 30, and cushioning cooling of the substrate 1 to some extent.

According to an embodiment of this application, the battery production device 100 further includes an air extraction piece 50, and the air extraction piece 50 communicates with the attachment piece 40.

In these optional embodiments, as shown in FIG. 4, the air extraction piece 50 is disposed, to facilitate controlling the attachment piece 40 to attach to or detach from the substrate 1.

According to an embodiment of this application, the attachment piece 40 at least partially protrudes from the heat exchange assembly 30.

In an embodiment of this application, the attachment piece 40 is disposed on the side, of the heat exchange assembly 30, that faces the substrate 1, and the attachment piece 40 at least partially protrudes from the heat exchange assembly 30. Therefore, the attachment piece 40 is first attached to a lower surface of the substrate 1. The attachment piece 40 protruding from the heat exchange assembly 30 creates a small gap between the substrate 1 and the heat exchange assembly 30. In this case, while cooling effect is achieved, the substrate 1 is prevented from suddenly being in contact with the extremely cold heat exchange assembly 30, allowing the substrate 1 to cool down gradually and stably.

Optionally, the attachment piece 40 uses a sucker.

According to an embodiment of this application, as shown in FIG. 4 and FIG. 5, the heat exchange assembly 30 includes a heat exchange plate 32, a recess portion 322 that is set back inwards is provided on a surface, of the heat exchange plate 32, that faces the substrate 1, and part of the attachment piece 40 is disposed in the recess portion 322.

Specifically, the heat exchange assembly 30 includes the heat exchange plate 32, and the heat exchange plate 32 has a first surface and a second surface along a thickness direction. The first surface faces the substrate 1, and the recess portion 322 that is set back inwards is provided on the first surface. One part of the attachment piece 40 is disposed in the recess portion 322, while the other part protrudes from the first surface.

In these optional embodiments, part of the attachment piece 40 is disposed in the recess portion 322, further reducing a gap between the heat exchange plate 32 and the substrate 1, improving efficiency of heat exchange, and enhancing effect of cooling the substrate 1.

According to an embodiment of this application, the attachment piece 40 is made of polytetrafluoroethylene.

In these optional embodiments, the attachment piece 40 made of polytetrafluoroethylene can effectively reduce damage to the attachment piece 40 caused by the high-temperature substrate 1. In addition, polytetrafluoroethylene is hydrophobic and oleophobic, effectively reducing oil contamination of the substrate 1.

According to an embodiment of this application, as shown in FIG. 4 and FIG. 5, the battery production device 100 further includes a drive piece 60, the drive piece 60 is connected to the heat exchange assembly 30, and the drive piece 60 drives the heat exchange assembly 30 to move upwards or downwards.

In an embodiment of this application, the battery production device 100 further includes a drive piece 60. The drive piece 60 may be disposed on the support 10, and move upwards or downwards relative to the support 10. The drive piece 60 is connected to the heat exchange assembly 30 and drives the heat exchange assembly 30 to move upwards or downwards, to control the heat exchange assembly 30 to attach to or detach from the substrate 1.

Specifically, after the conveyor mechanism 20 receives the substrate 1, or after the substrate 1 is conveyed to the predetermined position by the conveyor mechanism 20, the drive piece 60 drives the heat exchange assembly 30 to move upwards, so that the heat exchange assembly 30 is attached to the substrate 1 to exchange heat with the substrate 1. After the substrate 1 cools down to the preset temperature, the drive piece 60 drives the heat exchange assembly 30 to move downwards, and the conveyor mechanism 20 conveys the substrate 1 to the next process.

The drive piece 60 is a servo electrode, an air cylinder, a hydraulic cylinder, or the like.

Optionally, the drive piece 60 is a lifting cylinder.

In these optional embodiments, the drive piece 60 is disposed, to drive the heat exchange assembly 30 to move upwards or downwards. The heat exchange assembly 30 and the conveyor mechanism 20 operate independently of each other, reducing interference caused by the heat exchange assembly 30 to normal conveyance of the substrate 1 on the conveyor mechanism 20.

According to an embodiment of this application, as shown in FIG. 2, the battery production device 100 further includes a temperature detector 70, disposed on the support 10, and the temperature detector 70 is configured to detect a temperature of the substrate 1.

Optionally, the temperature detector 70 includes a temperature sensor.

In these optional embodiments, the temperature detector 70 is disposed, detecting cooling effect of the heat exchange assembly 30 in real time, and avoiding a problem of failing to cool the substrate 1 due to a malfunction in the heat exchange assembly 30.

A battery production device is provided. The battery production device includes a support, a conveyor mechanism, a heat exchange assembly, an attachment piece, an air extraction piece, a drive piece, and a temperature detector. The battery production device further includes a coating apparatus. The support is located downstream of the coating apparatus.

The conveyor mechanism is disposed on the support and configured to receive a substrate and convey the substrate. The conveyor mechanism includes two conveyor belts that are disposed along a first direction and spaced apart. The heat exchange assembly is disposed on two sides of the conveyor mechanism along the first direction. The heat exchange assembly is further disposed between the two adjacent conveyor belts. The first direction, a direction of conveying the substrate, and a vertical direction of the support are mutually perpendicular to each other.

The heat exchange assembly is movably disposed on the support and located on a path of conveying the substrate. The heat exchange assembly is configured to exchange heat with the substrate. The heat exchange assembly includes a heat exchange plate, a runner is provided within the heat exchange plate, and the runner is configured to guide flow of a heat exchange medium. A recess portion recessed inwards is provided on a surface of the heat exchange plate facing the substrate. The heat exchange plate is made of a material selected from an aluminum alloy.

The attachment piece is configured to be disposed on a side of the heat exchange assembly facing the substrate. One part of the attachment piece is disposed in the recess portion, while the other part of the attachment piece protrudes from the heat exchange assembly. The attachment piece is connected to the heat exchange assembly and configured to be attached to a lower surface of the substrate. The attachment piece is made of polytetrafluoroethylene.

The air extraction piece communicates with the attachment piece.

The drive piece is connected to the heat exchange assembly, and the drive piece drives the heat exchange assembly to move upwards or downwards.

The temperature detector is disposed on the support, and the temperature detector is configured to detect a temperature of the substrate.

After a substrate is conveyed by a battery production device, a temperature test and a water contact angle test are performed on the substrate. For the temperature test, an infrared temperature tester is used to separately test temperatures of upper and lower surfaces of the substrate at intervals. For the water contact angle test, a water contact angle tester is used to test a water contact angle of the substrate. A value of the water contact angle can reflect wettability of the substrate.

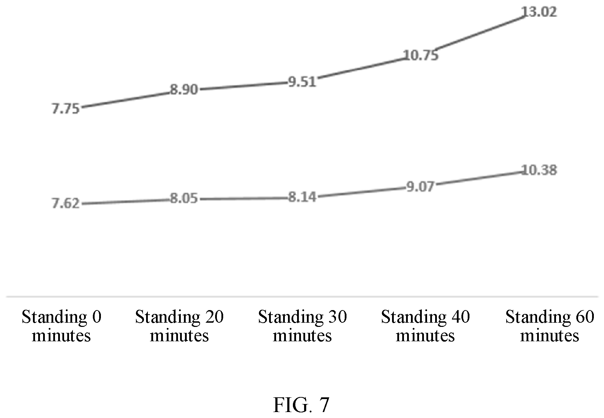

Test results are shown in FIG. 6 and FIG. 7. In FIG. 6, an upper curve is a cooling curve of the upper surface of the substrate, and a lower curve is a cooling curve of the lower surface of the substrate. It can be learned from FIG. 6 that, after a heat exchange assembly cools, for 150s, the high-temperature substrate that is processed by a coating apparatus, the upper and lower surfaces of the substrate reach a room temperature, and the lower surface cools down more noticeably. In FIG. 7, an upper curve is a water contact angle curve of the substrate that is not processed by the heat exchange assembly, and a lower curve is a water contact angle curve of the substrate that is processed by the heat exchange assembly for 90s. It can be learned from FIG. 7 that, after the water contact angle test is performed for the substrate that is processed by the heat exchange assembly for 90s and for the substrate that is not processed by the heat exchange assembly, values of a water contact angle of the lower surface of the substrate all decrease, and as a standing time increases, a value of the water contact angle of the lower surface of the substrate changes little overall, improving wettability.

Although this application has been described with reference to preferred embodiments, various improvements may be made to this application, and components therein may be replaced with equivalents, without departing from the scope of this application. In particular, provided that there is no structural conflict, technical features mentioned in the various embodiments may be combined in any manner. This application is not limited to the specific embodiments disclosed in this specification but includes all technical solutions falling within the scope of the claims.

## Claims

1. A battery production device, comprising:
a support;
a conveyor mechanism, disposed on the support and configured to receive a substrate and convey the substrate; and
a heat exchange assembly, disposed on the support and located on a path of conveying the substrate, wherein the heat exchange assembly is configured to exchange heat with the substrate.

2. The battery production device according to claim 1, wherein
the heat exchange assembly is disposed on at least two sides of the conveyor mechanism along a first direction, and the first direction, a direction of conveying the substrate, and a vertical direction of the support are mutually perpendicular to each other.

3. The battery production device according to claim 1 or 2, wherein
the conveyor mechanism comprises a plurality of conveyor belts spaced apart the first direction, and the heat exchange assembly is further disposed between two adjacent ones of the conveyor belts.

4. The battery production device according to any one of claims 1 to 3, wherein
an upper side of the heat exchange assembly has a heat exchange plane, and the heat exchange plane is configured to be attached to the substrate.

5. The battery production device according to any one of claims 1 to 4, wherein
the heat exchange assembly comprises a heat exchange plate, a runner is provided within the heat exchange plate, and the runner is configured to guide flow of a heat exchange medium.

6. The battery production device according to claim 5, wherein
the heat exchange plate is made of a material selected from aluminum or an aluminum alloy.

7. The battery production device according to any one of claims 1 to 6, wherein
the battery production device further comprises an attachment piece, the attachment piece is configured to be disposed on a side of the heat exchange assembly facing the substrate, and the attachment piece is connected to the heat exchange assembly and configured to be attached to the substrate.

8. The battery production device according to claim 7, wherein
the battery production device further comprises an air extraction piece, and the air extraction piece communicates with the attachment piece.

9. The battery production device according to claim 7, wherein
the attachment piece at least partially protrudes from the heat exchange assembly.

10. The battery production device according to claim 9, wherein
the heat exchange assembly comprises a heat exchange plate, a recess portion recessed inwards is provided on a surface of the heat exchange plate facing the substrate, and part of the attachment piece is disposed in the recess portion.

11. The battery production device according to claim 7, wherein
the attachment piece is made of polytetrafluoroethylene.

12. The battery production device according to any one of claims 1 to 11, wherein
the battery production device further comprises a drive piece, the drive piece is connected to the heat exchange assembly, and the drive piece drives the heat exchange assembly to move upwards or downwards.

13. The battery production device according to any one of claims 1 to 12, wherein
the battery production device further comprises a temperature detector disposed on the support, and the temperature detector is configured to detect a temperature of the substrate.
